(19)

Europäisches
Patentamt
European
Patent Office
Office européen
des brevets

(11) **EP 3 683 812 B1**

(12) **EUROPEAN PATENT SPECIFICATION**

(45) Date of publication and mention
of the grant of the patent:
**22.12.2021 Bulletin 2021/51**

(21) Application number: **19152300.0**

(22) Date of filing: **17.01.2019**

(51) Int Cl.:
*H01G 4/30* *(2006.01)*      *H01G 4/33* *(2006.01)*
*H01G 4/35* *(2006.01)*      *H01G 4/38* *(2006.01)*
*H01G 4/232* *(2006.01)*     *H01L 49/02* *(2006.01)*
*H01L 29/06* *(2006.01)*

(54) **CAPACITOR ARRAY WITH STAGGERED LAYER STRUCTURE FOR MILLIMETER WAVE FREQUENCY BAND**

KONDENSATORANORDNUNG MIT VERSETZTER SCHICHTSTRUKTUR FÜR EIN MILLIMETERWELLENFREQUENZBAND

RÉSEAU DE CONDENSATEUR À STRUCTURE DE COUCHE EN QUINCONCE POUR BANDE DE FRÉQUENCE D'ONDES MILLIMÉTRIQUES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**22.07.2020 Bulletin 2020/30**

(73) Proprietor: **National Chung-Shan Institute of Science and Technology**
**325 Taoyuan City (TW)**

(72) Inventors:
• **Peng, Shao-Wei**
**Hsinchu County 310 (TW)**

• **Chou, Hung-Ting**
**New Taipei City 242 (TW)**
• **Yu, Chien-Te**
**Taoyuan City 320 (TW)**

(74) Representative: **Straus, Alexander et al**
**2K Patent- und Rechtsanwälte - München**
**Keltenring 9**
**82041 Oberhaching (DE)**

(56) References cited:
**US-A1- 2005 017 320      US-A1- 2010 084 738**
**US-A1- 2010 134 213      US-B1- 6 434 730**

## Description

Field of the Invention

The present invention relates to a capacitor array with staggered layer structure, and more particularly, to a capacitor array with staggered layer structure for millimeter wave frequency band.

Background of the Invention

Most conventional multi-layer capacitors are formed of ceramic dielectric materials or the like. Such multi-layer capacitors include a capacitor having a plurality of laminated dielectric layers, a plurality of pairs of mutually opposed first inner electrodes and a plurality of pairs of mutually opposed second inner electrodes alternately disposed in a direction in which the dielectric layers are laminated, the pairs of first inner electrodes and the second inner electrodes opposing via the dielectric layers so as to define a plurality of capacitor units.

In a high frequency circuit (e.g., millimeter wave frequency band from 5GHz to 160GHz) including a power supply line, which is used for a micro processing unit incorporating such a multi-layer capacitor, both the multi-layer capacitor and the micro processing unit must follow the design rule (e.g., metal density rule) for the same CMOS (Complementary Metal-Oxide-Semiconductor) process.

Document D1 (US2010/084738 A1) discloses a capacitive element formed in a shape of loop for surrounding a circuit that generates high-frequency power or needs to be protected from high-frequency power. The capacitive element operates as a bypass of the high-frequency power to suppress electromagnetic waves due to spatial coupling.

Document D2 (US 2010/134213 A1) discloses an electromagnetic bandgap structure which can function as a band stop filter to block a conductive noise of a certain frequency band. Document D2 discloses to connect multiple adjacent metal plates by multiple stitching vias in order to create the band stop filter.

Document D3 (US 6,434,730 B1) and document D4 (US 2005/017320 A1) disclose a semiconductor device including a bypass capacitor including a metal-oxide semiconductor (MOS) structure.

Therefore, in consideration of conduction noise suppression and conduction loss improvement for the transmitted signal, how to design the capacitor unit and array with staggered layer structure for millimeter wave frequency band and adapted to the CMOS process has become a topic in the industry.

Summary of the Invention

This in mind, the application aims at providing a capacitor array with staggered layer structure for millimeter wave frequency band.

This is achieved by a capacitor unit with staggered-layer structure for a capacitor array according to claim 1. The dependent claims pertain to corresponding further developments and improvements.

As will be seen more clearly from the detailed description following below, an embodiment of the present invention discloses a capacitor unit with staggered-layer structure, comprising a plurality of odd layers, wherein each of the plurality of odd layers is formed with a first slot, and not adjacent to another one of the plurality of odd layers; a first via formed in the first slot; a plurality of first connecting portion corresponding to the plurality of odd layers, formed in the first slot, and configured to connect the first via and the plurality of odd layers; a plurality of even layers, wherein each of the plurality of even layers is formed with a second slot, and not adjacent to another one of the plurality of even layers; a second via formed in the second slot; and a plurality of second connecting portion corresponding to the plurality of even layers, formed in the second slot, and configured to connect the second via and the plurality of even layers; wherein one of the plurality of odd layers is adjacent to one of the plurality of even layers to form a staggered-layer structure.

The capacitor unit with staggered-layer structure provides is applicable for CMOS process to be utilized as a power source trace as well as density cell to satisfy design rule for metal density. A plurality of the capacitor units may be coupled and arranged to be the capacitor array adapted to at least one of alignment, non-alignment, overlapping and non-overlapping designs. Moreover, the capacitor array with staggered-layer structure provides characteristics of wide bandwidth, smooth and low impedance, and low conduction loss for bypass capacitor design, which is suitable for power source trace for millimeter wave frequency band.

Brief Description of the Drawings

FIG. 1 illustrates an isotropic view of a capacitor unit according to an embodiment of the present invention.
FIG. 2 illustrates a top view of the capacitor unit in FIG. 1.
FIG. 3 illustrates a sectional view of the capacitor unit 10 in FIG. 1.
FIG. 4 is a top view of an odd layer of the capacitor unit 10 in FIG. 1.
FIG. 5 is a top view of an even layer of the capacitor unit 10 in FIG. 1.
FIG. 6 is a sectional view of odd layers of the capacitor unit 10 in FIG.1.
FIG. 7 is a sectional view of even layers of the capacitor unit 10 in FIG. 1.
FIG. 8 illustrates a top view of a 2*2 capacitor array according to an embodiment of the present invention.

FIG. 9 illustrates a top view of a 2*2 capacitor array according to an embodiment of the present invention.

FIG. 10 illustrates a top view of a 2*2 capacitor array according to an embodiment of the present invention.

FIG. 11 illustrates a top view of a 2*2 capacitor array according to an embodiment of the present invention.

FIG. 12 is an isotropic view of a capacitor array according to an embodiment of the present invention.

FIG. 13 is a simulated impedance to frequency diagram of the capacitor array.

FIG. 14 is a simulated capacitance to frequency diagram of the capacitor array.

FIG. 15 is an isotropic view of a distributed bypass capacitor array according to an embodiment of the present invention.

FIG. 16 is a transmitter comprising an equivalent circuit of the distributed bypass capacitor array in FIG. 15.

FIG. 17 is an isotropic view of a lumped bypass capacitor array according to an embodiment of the present invention.

FIG. 18 is a transmitter comprising an equivalent circuit of the lumped bypass capacitor array in FIG. 17.

FIG. 19 is a simulated impedance to frequency diagram of the distributed bypass capacitor array and the lumped bypass capacitor array.

FIG. 20 is a simulated isolation to frequency diagram of the distributed bypass capacitor array and the lumped bypass capacitor array.

FIG. 21 illustrates a conduction loss of a CMOS process transmitting circuit and corresponding equivalent circuit.

FIG. 22 illustrates an equivalent circuit of a capacitor for parallel-plates model.

FIG. 23 illustrates an equivalent circuit of a capacitor unit with staggered-layer structure.

Detailed Description

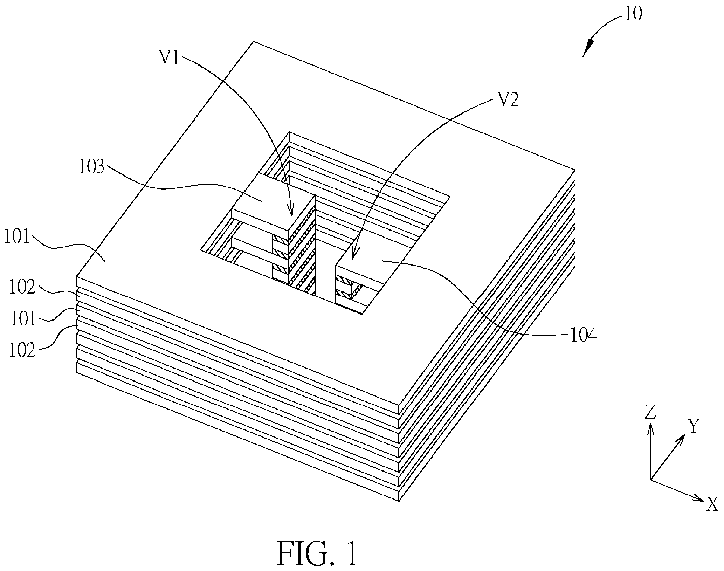

FIG. 1 illustrates an isotropic view of a capacitor unit 10 according to an embodiment of the present invention. The capacitor unit 10 includes odd layers 101, even layers 102, vias V1 and V2, and connecting portions 103 and 104. The capacitor unit 10 may be utilized in a transmitter operating in millimeter wave frequency band, e.g. 5-160GHz frequency band. The odd layers 101, the even layers 102, the vias V1 and V2, and the connecting portions 103 and 104 are made of metal.

As shown in FIG. 1, the capacitor unit 10 is formed with a staggered structure comprising the odd layers 101 and the even layers 102 with rectangular topology. A sub capacitor may be formed by coupling one of the odd layers 101 with neighboring one of the even layers 102.

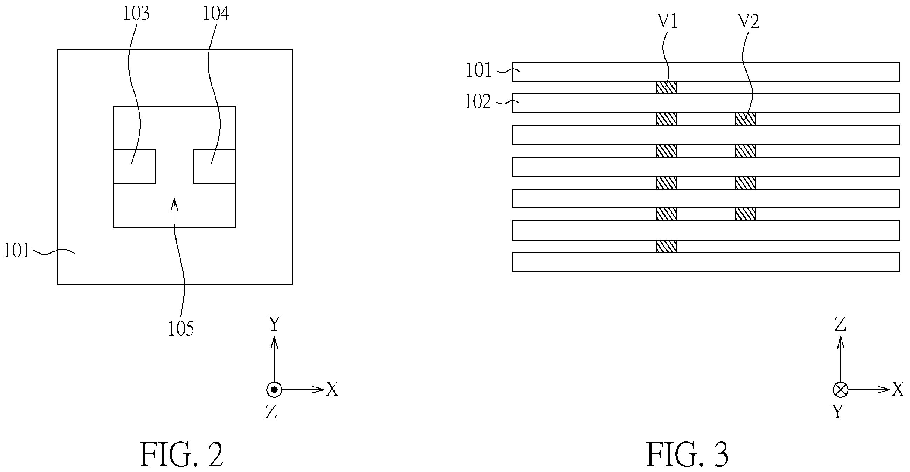

FIG. 2 illustrates a top view of the capacitor unit 10 in FIG. 1. The odd layers 101 and the even layers 102 with rectangular topology are formed with slots 105 to obey design rules for capacitor array structure, e.g., a total width of the capacitor array structure may not be too wide or a total metal density of the capacitor array structure may not be too high.

FIG. 3 illustrates a sectional view of the capacitor unit 10 in FIG. 1. The vias V1 and V2 and the connecting portions 103 and 104 are formed inside the slots 105. The connecting portions 103 are configured to connect the via V1 and the odd layers 101, and the connecting portions 104 are configured to connect the via V2 and the even layers 102.

In such a structure, there is a high flexibility of connections between the capacitor unit 10 and other metal elements. For example, the capacitor unit 10 may connect to other metal elements through any sides of the rectangular topology, and any one of the odd layers 101, any one of the even layers 102.

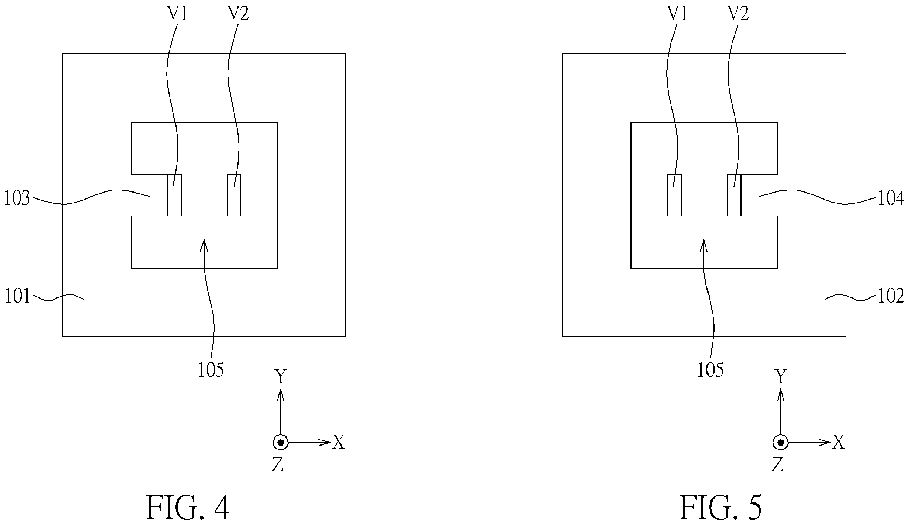

FIG. 4 is a top view of an odd layer of the capacitor unit 10 in FIG. 1, wherein the via V1 is configured to connect the odd layers 101 through the connecting portions 103. FIG. 5 is a top view of an even layer of the capacitor unit 10 in FIG. 1, wherein the via V2 is configured to connect the even layers 102 through the connecting portions 104.

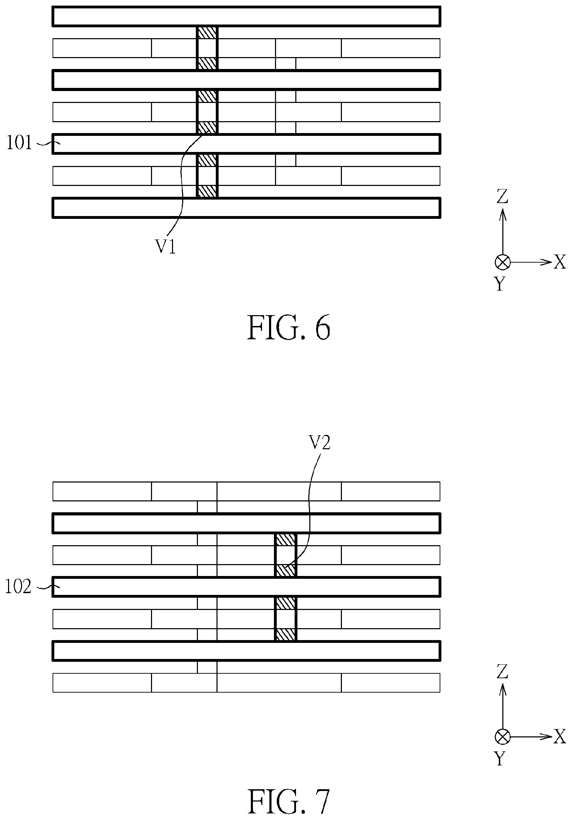

FIG. 6 is a sectional view of odd layers of the capacitor unit in FIG.1, wherein the via V1 is configured to connect the first, third, fifth and seventh layers to ensure they have a same electric potential. FIG. 7 is a sectional view of even layers of the capacitor unit in FIG. 1, wherein the via V2 is configured to connect the second, fourth and sixth layers to ensure they have a same electric potential. In this embodiment, there are seven layers in total in the capacitor unit 10, which is not limited. In the present invention, the staggered structure of the capacitor array is applicable for at least four layers. In other words, a first number of the plurality of odd layers and a second number of the plurality of even layers are integers greater than 1.

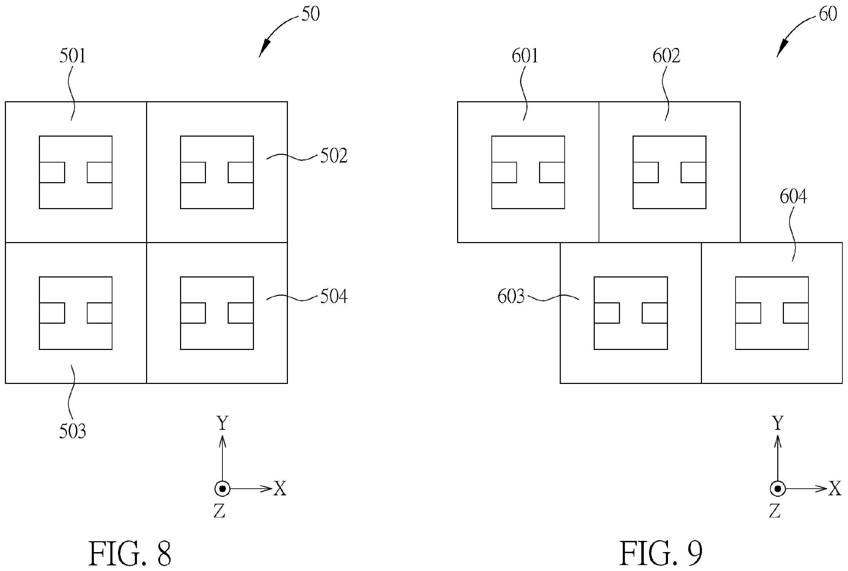

A plurality of the capacitor units 10 may be arranged and coupled together to form a capacitor array of an m*n matrix, wherein m and n are integers greater than zero. For example, FIG. 8 illustrates a top view of a 2*2 capacitor array 50 according to an embodiment of the present invention.

The capacitor array 50 includes four capacitor units 501, 502, 503 and 504. The capacitor unit 501 is formed adjacent to the capacitor units 502 and 503, and not adjacent to the capacitor unit 504. Two horizontal edges of the capacitor unit 501 along a first direction (e.g., X direction) are aligned with two horizontal edges of the capacitor unit 502, and two vertical edges of the capacitor unit 501 along a second direction (e.g., Y direction) are aligned with two vertical edges of the capacitor unit 503. Projections of the capacitor units 501, 502, 503 and 504 onto a plane formed by the first direction and the second direction (e.g., XY plane) are not overlapped.

FIG. 9 illustrates a top view of a 2*2 capacitor array 60 according to an embodiment of the present invention. The capacitor array 60 includes four capacitor units 601, 602, 603 and 604. The capacitor unit 601 is formed adjacent to the capacitor units 602 and 603, and not adjacent to the capacitor unit 604. Two horizontal edges of the capacitor unit 601 along a first direction (e.g., X direction) are aligned with two horizontal edges of the capacitor unit 602 and one horizontal edge of the capacitor units 603 and 604, and two vertical edges of the capacitor unit 601 along a second direction (e.g., Y direction) are not aligned with any vertical edges edge of the capacitor units 603 and 604. Projections of the capacitor units 601, 602, 603 and 604 onto the XY plane are not overlapped.

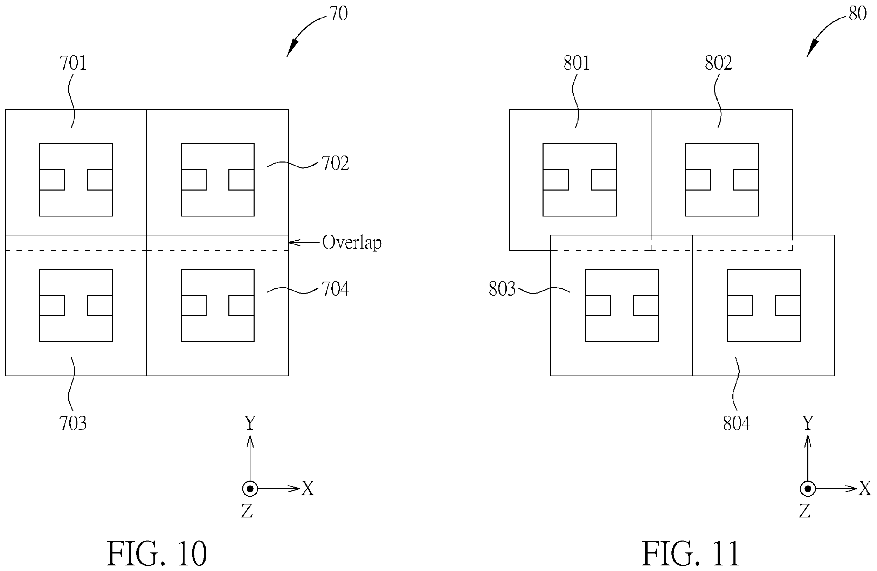

FIG. 10 illustrates a top view of a 2*2 capacitor array 70 according to an embodiment of the present invention. The capacitor array 70 includes four capacitor units 701, 702, 703 and 704. The capacitor unit 701 is formed adjacent to the capacitor unit 702. Two horizontal edges of the capacitor unit 701 along a first direction (e.g., X direction) are aligned with two horizontal edges of the capacitor unit 702, and two vertical edges of the capacitor unit 701 along a second direction (e.g., Y direction) are aligned with two vertical edges of the capacitor unit 703. A projection of the capacitor unit 701 onto the XY plane is overlapped with a projection of the capacitor unit 703, and the projection of the capacitor unit 701 is not overlapped with projections of the capacitor units 702 and 704 onto the XY plane.

FIG. 11 illustrates a top view of a 2*2 capacitor array 80 according to an embodiment of the present invention. The capacitor array 80 includes four capacitor units 801, 802, 803 and 804. The capacitor unit 801 is formed adjacent to the capacitor units 802. Two horizontal edges of the capacitor unit 801 along a first direction (e.g., X direction) is aligned with two horizontal edges of the capacitor unit 802, and vertical edges of the capacitor unit 801 along a second direction (e.g., Y direction) is not aligned with any vertical edge of the capacitor unit 803. A projection of the capacitor units 801 onto the XY plane is overlapped with a projection of the capacitor unit 803, and the projection of the capacitor unit 801 is not overlapped with projections of the capacitor units 802 and 804 onto the XY plane.

Note that sizes of the capacitor units may be determined according to design rules (e.g., metal width, spacing, and density rules) for CMOS (Complementary Metal-Oxide-Semiconductor) process. For example, the width of traces of the odd and even layers and connecting portions may be determined according to the metal width rule, and the area of the slot formed in the odd and even layers may be determined according to the metal spacing and density rules for CMOS process.

The capacitance C of a parallel-plates model is denoted as a function of $C = \epsilon \cdot \frac{A}{d}$, wherein A is an area of two of the parallel-plates, d is a distance between the two parallel-plates, and $\epsilon$ is a permittivity of a dielectric between the two parallel-plates.

The impedance Z of the capacitance C is denoted as a function of $Z = \frac{1}{\omega \cdot C} \cdot \left( \frac{Q+1}{Q} \right)$, wherein $\omega$ is angular frequency, Q is quality factor. Accordingly, under a same distance and a varying frequency, an impedance of a distributed bypass capacitor varies smoother than an impedance of a lumped bypass capacitor.

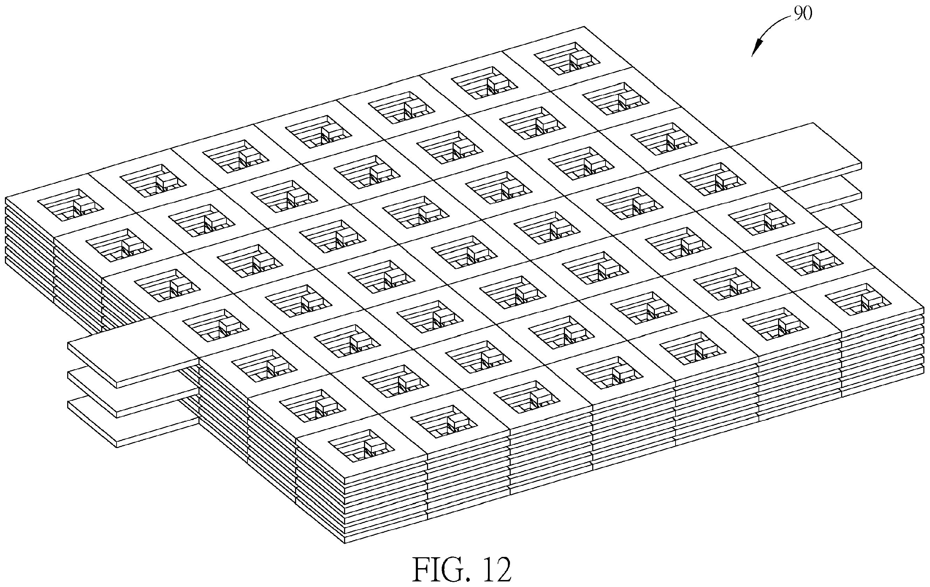

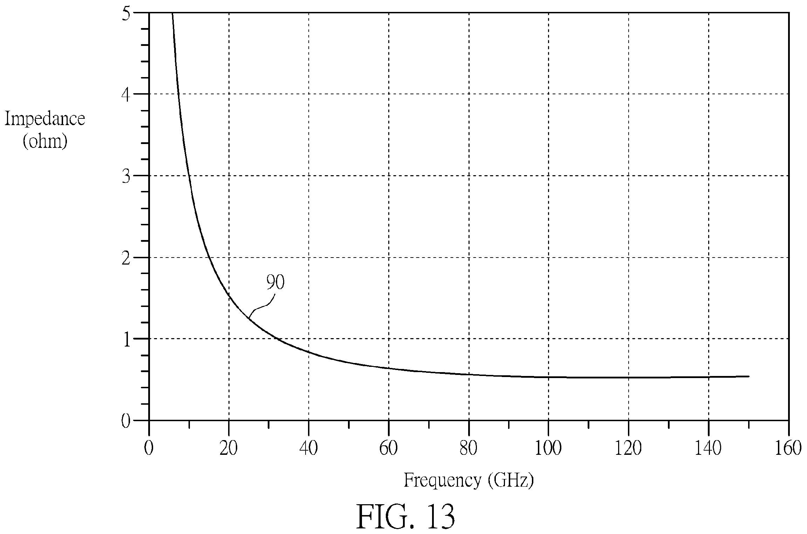

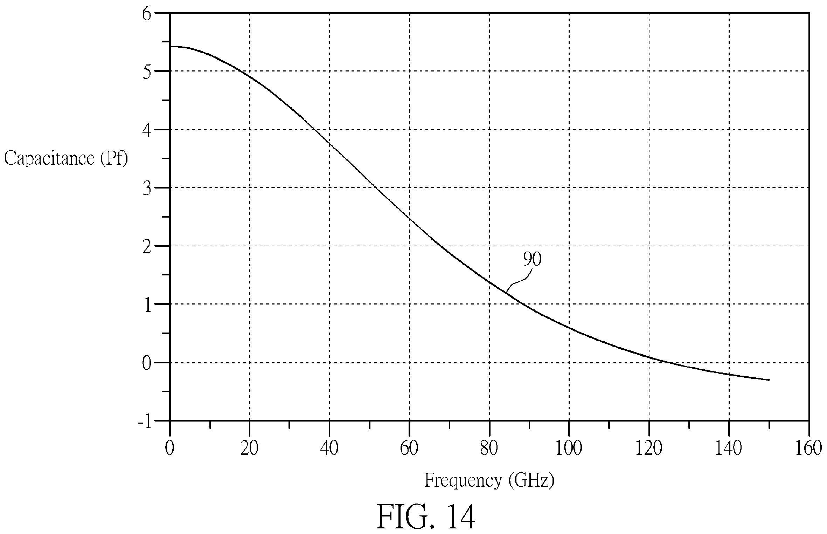

Specifically, FIG. 12 is an isotropic view of a capacitor array 90 according to an embodiment of the present invention. The capacitor array 90 includes 7*7 capacitor units with an area of 56*56um². FIG. 13 is a simulated impedance to frequency diagram of the capacitor array 90. As observed from FIG. 13, the capacitor array 90 has a characteristics of wide bandwidth and low (and smooth) impedance for bypass capacitor design. FIG. 14 is a simulated capacitance to frequency diagram of the capacitor array 90. As observed from FIG. 14, the simulated capacitance for 100MHz is 5.4pF.

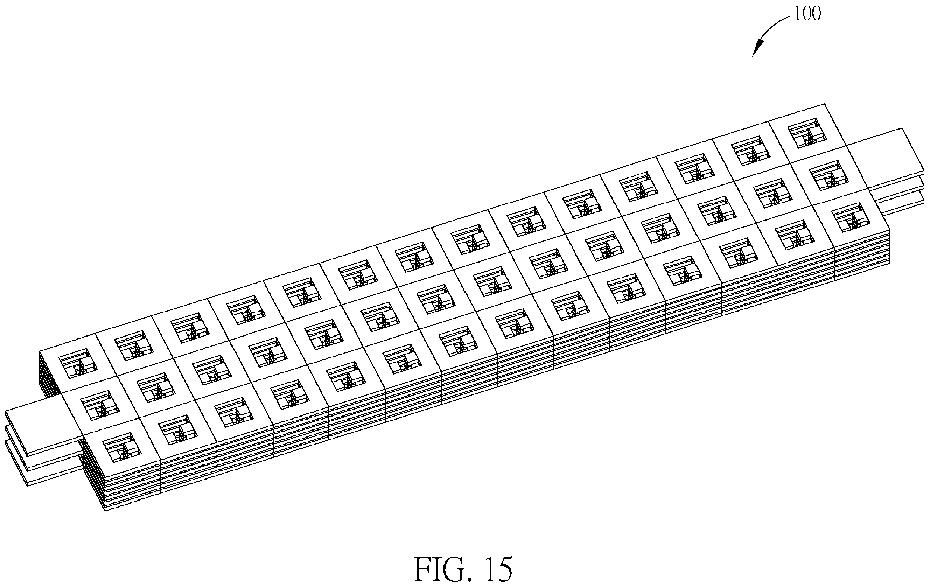

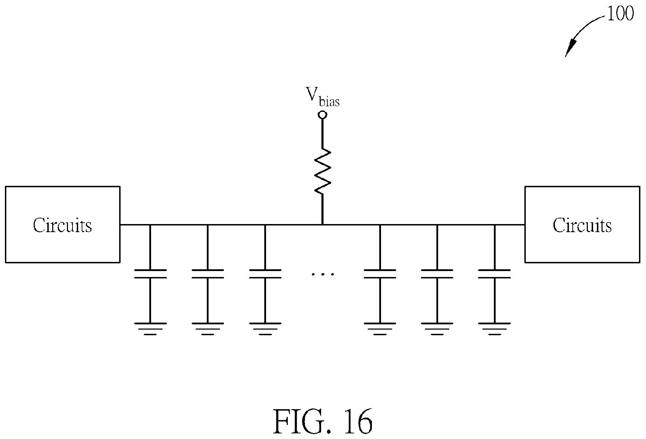

FIG. 15 is an isotropic view of a distributed bypass capacitor array 100 according to an embodiment of the present invention. The capacitor array 100 includes 14*3=42 capacitor units. FIG. 16 is a transmitter comprising an equivalent circuit of the distributed bypass capacitor array 100 in FIG. 15. As observed from FIG. 16, a capacitor sub-array including 1*3 capacitor units may be represented by a sub-capacitor, and there are 14 sub-capacitors connected in parallel between two circuits. In this embodiment, one end of the capacitor sub-array is coupled to a power source $V_{bias}$ and between two circuits (or radio-frequency signals), and another end of the capacitor sub-array is coupled to a ground. A distance between the two circuits is 112um (micro meters).

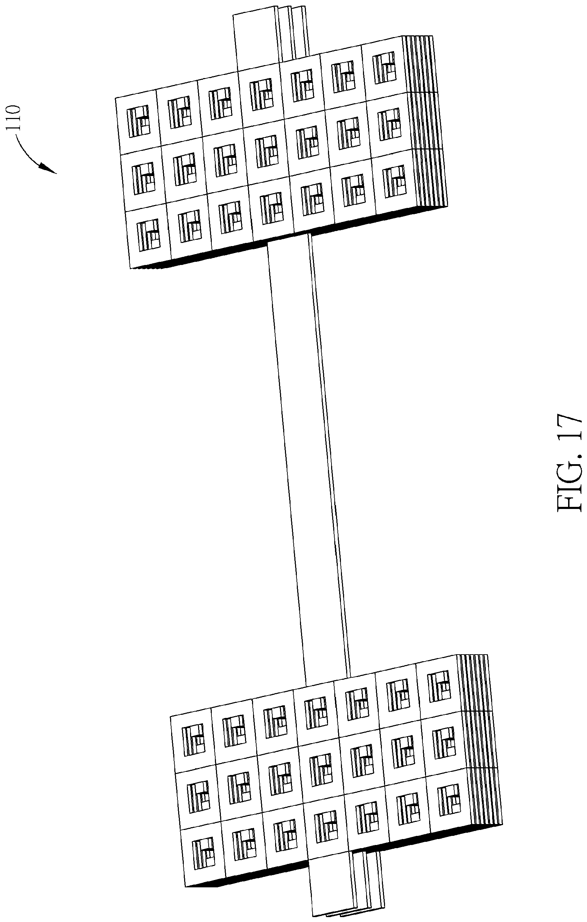

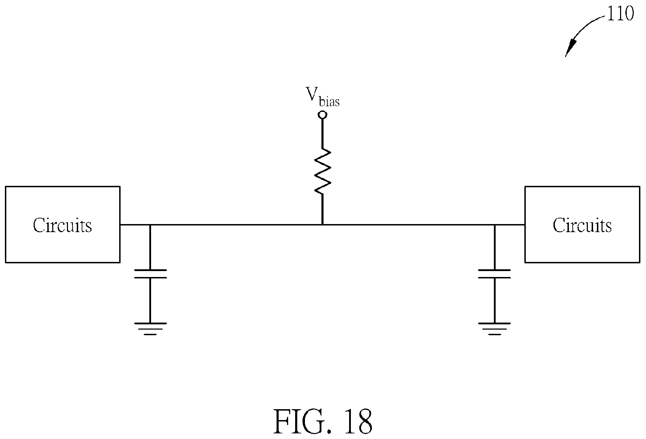

FIG. 17 is an isotropic view of a lumped bypass capacitor array 110 according to an embodiment of the present invention. The capacitor array 110 includes 3*7*2=42 capacitor units, and there are two capacitor sub-array including 3*7=21 capacitor units and a transmission line with 50ohm for connecting the 2 sub-capacitors with 21 capacitor units. FIG. 18 is a transmitter comprising an equivalent circuit of the lumped bypass capacitor array 110 in FIG. 17. As observed from FIG. 18, one capacitor sub-array including 3*7=21 capacitor units may be represented by a sub-capacitor, and there are 2 sub-capacitors connected in parallel between two circuits. In this embodiment, one end of the capacitor sub-array is coupled to a power source $V_{bias}$ and between two circuits (or radio-frequency signals), and another end of the capacitor sub-array is coupled to a ground. A distance between the two circuits is 112um (micro meters).

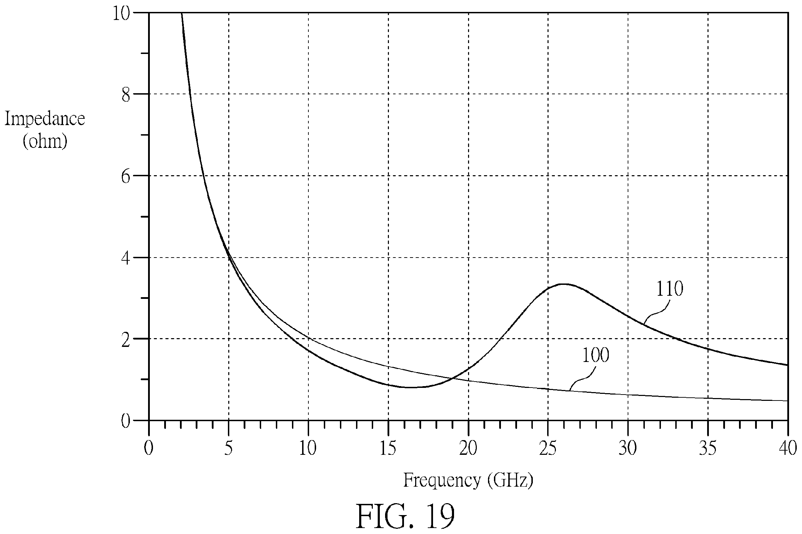

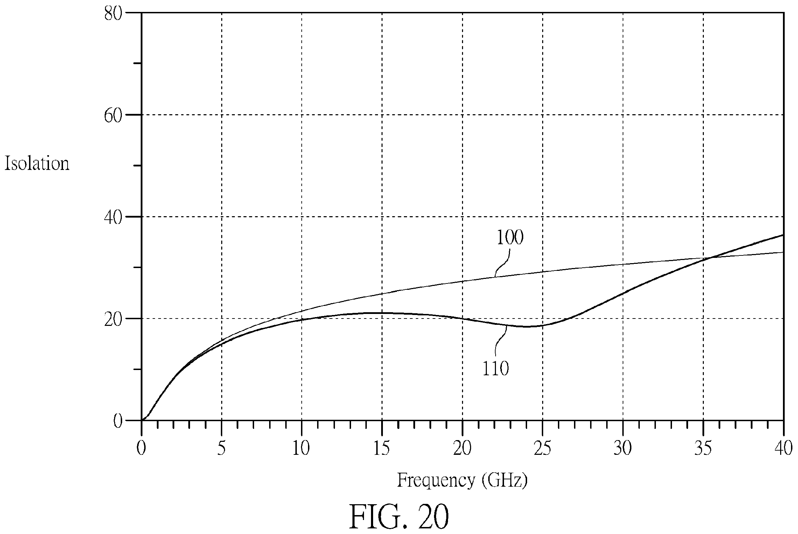

FIG. 19 is a simulated impedance to frequency diagram of the distributed bypass capacitor array 100 and the lumped bypass capacitor array 110. FIG. 20 is a simulated isolation to frequency diagram of the distributed bypass capacitor array 100 and the lumped bypass capacitor array 110. In FIG. 19 and 20, the impedance and isolation curves for the distributed bypass capacitor array 100 are denoted with a thin line, and the impedance and isolation curves for the lumped bypass capacitor array 110 are denoted with a thick line.

Note that both of the distributed bypass capacitor array 100 and the lumped bypass capacitor array 110 includes 42 capacitor units in total, and the distance of them are 112um. As observed from FIG. 19, the impedance of the lumped bypass capacitor array 110 rises at 26GHz due to transmission line resonation. While the impedance of the distributed bypass capacitor array 100 is smooth without additional resonation, which provides more stable characteristics for bypass capacitor design. As observed from FIG. 20, the isolation of the lumped bypass capacitor array 110 decreases at 24GHz due to transmission line resonation. While the isolation of the distributed bypass capacitor array 100 is smooth without additional resonation, which provides more stable characteristics for bypass capacitor design.

In summary of the embodiment of FIG. 1 to FIG.20,

(i) when using CMOS process, the capacitor unit may be utilized as a power source trace as well as density cell to satisfy design rule for metal density;
(ii) a plurality of the capacitor units may be coupled and arranged to be the capacitor array 50 as shown in FIG. 8 for alignment and non-overlapping design;
(iii) a plurality of the capacitor units may be coupled and arranged to be the capacitor arrays 60, 70, and 80 as shown in FIG. 9 to FIG. 8 for non-alignment and overlapping design;
(iv) the capacitor unit may be utilized for power source trace for millimeter wave band, wherein the odd (or even) layers are coupled to a ground, the remaining (even or odd) layers are coupled to the power source (and the circuits), and the capacitor unit operates as the bypass capacitor to have impedance with the characteristics of wide bandwidth and low impedance to provide smooth and stable bypass capacitor design;
(v) the transmission line of the lumped bypass capacitor array produces conduction loss and resonation to cause voltage drop(or IR drop for V=IR), and the distributed bypass capacitor array may solve the voltage drop due to the conduction loss and resonation.

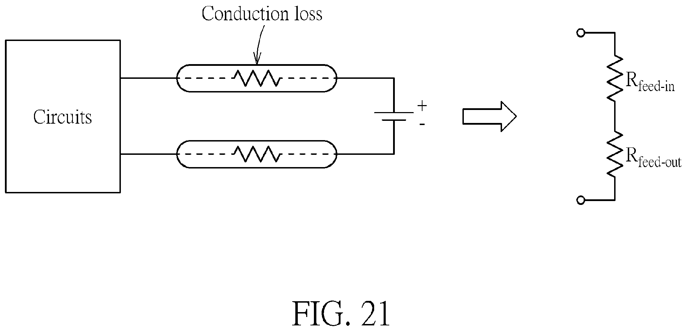

FIG. 21 illustrates a conduction loss of a CMOS process transmitting circuit and corresponding equivalent circuit. For thin metal CMOS process, the conduction loss should take considerations of power source feed-in line and return current route. Therefore, the equivalent circuit for conduction loss includes a feed-in resistance $R_{feed-in}$ for the power source feed-in line and a feed-out resistance $R_{feed-out}$ for the return current route.

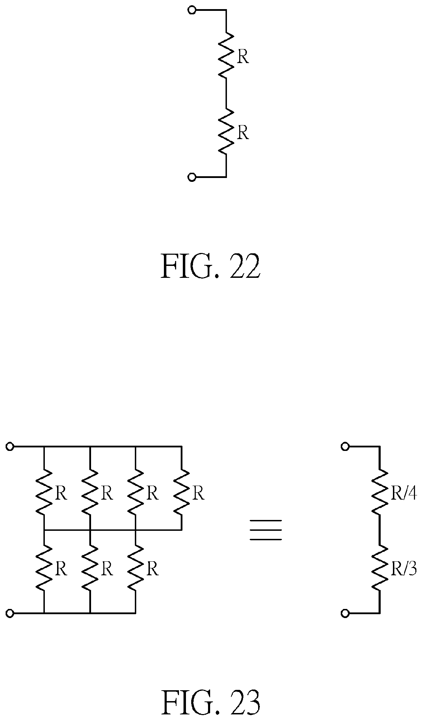

FIG. 22 illustrates an equivalent circuit of a capacitor for parallel-plates model. Consider the conduction loss, given that a feed-in resistance R is equal to a feed-out resistance R, so a total resistance is 2*R.

FIG. 23 illustrates an equivalent circuit of a capacitor unit with staggered-layer structure. Consider the conduction loss, given that a feed-in resistance is equivalent to four paralleled feed-in resistance R/4 (e.g., there are four odd layers in the capacitor unit), a feed-out resistance is equivalent to three paralleled feed-in resistance R/3 (e.g., there are three even layers in the capacitor unit), so a total resistance is R/4+ R/3=7/12*R.

As observe from FIG. 22 and FIG. 23, the total resistance of the capacitor unit of the present invention is smaller than the total resistance of the capacitor for parallel-plates model, i.e., 7/12*R is smaller than 2*R, to improve voltage drop (IR drop) due to conduction loss.

To sum up, the capacitor array with staggered-layer structure provides is applicable for CMOS process to be utilized as a power source trace as well as density cell to satisfy design rule for metal density. A plurality of the capacitor units may be coupled and arranged to be the capacitor array adapted to at least one of alignment, non-alignment, overlapping and non-overlapping designs. Moreover, the capacitor array with staggered-layer structure provides characteristics of wide bandwidth, smooth and low impedance, and low conduction loss for bypass capacitor design, which is suitable for power source trace for millimeter wave frequency band.

**Claims**

1. A capacitor unit (10) with staggered-layer structure, for a capacitor array comprising a plurality of capacitor units in which one and another of the plurality capacitor units are seamlessly connected side by side, **characterized by** comprising:

a plurality of odd layers (101), wherein each of the plurality of odd layers (101) is formed with a first slot (105), and not adjacent to another one of the plurality of odd layers (101);
a first via (V1) formed in the first slot (105);
a plurality of first connecting portion (103) corresponding to the plurality of odd layers (101), formed in the first slot (105), and configured to connect the first via (V1) and the plurality of odd layers (101);
a plurality of even layers (102), wherein each of the plurality of even layers (102) is formed with a second slot (105), and not adjacent to another one of the plurality of even layers (102);
a second via formed in the second slot (105); and
a plurality of second connecting portion (104) corresponding to the plurality of even layers (102), formed in the second slot (105), and configured to connect the second via (V2) and the plurality of even layers (102);

wherein one of the plurality of odd layers (101) is adjacent to one of the plurality of even layers (102) to form a staggered-layer structure.

2. The capacitor unit of claim 1, **characterized in that** the plurality of odd layers (101), the first slot (105), the plurality of even layers (102), the second slot (105) are formed with a rectangular topology.

3. The capacitor unit of claim 1, **characterized in that** a first number of the plurality of odd layers (101) and a second number of the plurality of even layers (102) are integers greater than 1.

4. The capacitor unit of claim 1, **characterized in that** a plurality of capacitor units is arranged to form the capacitor array of an m*n matrix, wherein m and n are integers greater than zero.

5. The capacitor unit of claim 1, **characterized in that** the capacitor array (50) comprises:

   a first capacitor unit (501);
   a second capacitor unit (502) coupled and adjacent to the first capacitor unit 501);
   a third capacitor unit (503) coupled and adjacent to the first capacitor unit (501); and
   a fourth capacitor unit (504) coupled and adjacent to the second capacitor unit 502) and third capacitor unit (503), and not adjacent to the first capacitor unit (501);
   wherein horizontal edges of the first capacitor unit along a first direction (X) is aligned with horizontal edges of the second capacitor unit (502), and vertical edges of the first capacitor unit (501) along a second direction (Y) is aligned with vertical edges of the third capacitor unit (503);
   wherein projections of the first, second, third and fourth capacitor units (501, 502, 503, 504) onto a plane formed by the first and second directions (X, Y) are not overlapped.

6. The capacitor unit of claim 1, **characterized in that** the capacitor array (60) comprises:

   a first capacitor unit (601);
   a second capacitor unit (602) coupled and adjacent to the first capacitor unit (601);
   a third capacitor unit (603)coupled and adjacent to the first capacitor unit (601); and
   a fourth capacitor unit (604)coupled and adjacent to the second and third capacitor units (602, 603), and not adjacent to the first capacitor unit (601);
   wherein two horizontal edges of the first capacitor unit (601) along a first direction (X) are aligned with two horizontal edges of the second capacitor unit (602), one horizontal edge of the third capacitor unit (603), and one horizontal edge of the fourth capacitor unit (604);
   wherein two vertical edges of the first capacitor unit (601) along a second direction (Y) are not aligned with any vertical edge of the third and fourth capacitor units (603, 604);
   wherein projections of the first, second, third and fourth capacitor units (601, 602, 603, 604) onto a plane formed by the first and second directions (X, Y) are not overlapped.

7. The capacitor unit of claim 1, **characterized in that** the capacitor array (70) comprises:

   a first capacitor unit (701);
   a second capacitor unit (702) coupled and adjacent to the first capacitor unit (701);
   a third capacitor unit (703); and
   a fourth capacitor unit (704) coupled and adjacent to the third capacitor unit (703);
   wherein two horizontal edges of the first capacitor unit (701) along a first direction (X) are aligned with two horizontal edges of the second capacitor unit (702), and two vertical edges of the first capacitor unit (701) along a second direction (Y) are aligned with two vertical edges of the third capacitor unit (703);
   wherein a projection of the first capacitor unit (701) onto a plane formed by the first and second directions (X, Y) is overlapped with a projection of the third capacitor unit (703), and the projection of the first capacitor unit (701) is not overlapped with projections of the second and fourth capacitor units (702, 704) onto the plane.

8. The capacitor unit of claim 1, **characterized in that** the capacitor array (80) comprises:

   a first capacitor unit (801);
   a second capacitor unit (802) coupled and adjacent to the first capacitor unit (801);
   a third capacitor unit (803); and
   a fourth capacitor unit (804) coupled and adjacent to the third capacitor unit (803);
   wherein two horizontal edges of the first capacitor unit (801) along a first direction (X) are aligned with two horizontal edges of the second capacitor unit (802);
   wherein two vertical edges of the first capacitor unit (801) along a second direction (Y) are not aligned with any vertical edge of the third capacitor unit (803);
   wherein a projection of the first capacitor units (801) onto a plane formed by the first and second directions (X, Y) is overlapped with a projection of the third capacitor unit (803), and the projection of the first capacitor unit (801) is not overlapped with projections of the second and fourth capacitor units (802, 804) onto the plane.

9. The capacitor unit of claim 1, **characterized in that** the plurality of odd layers (101) are connected to a power source and a radio-frequency signal, and the plurality of even layers (102) are connected to a ground.

**Patentansprüche**

1. Kondensatoreinheit (10) mit gestaffelter Schichtstruktur für eine Kondensatoranordnung, die mehrere Kondensatoreinheiten umfasst, worin einer und ein weiterer der mehreren Kondensatoreinheiten nahtlos nebeneinander verbunden sind, **dadurch gekennzeichnet, dass** diese umfasst:

   mehrere ungerade Schichten (101), worin jede der mehreren ungeraden Schichten (101) mit einem ersten Schlitz (105) ausgebildet ist und nicht an eine andere der mehreren ungeraden Schichten (101) angrenzt;
   einen ersten Durchgang (V1), der in dem ersten Schlitz (105) ausgebildet ist;
   mehrere erste Verbindungsabschnitte (103), die den mehreren ungeraden Schichten (101) entsprechen, die in dem ersten Schlitz (105) ausgebildet sind und ausgestaltet sind, den ersten Durchgang (V1) und die mehreren ungeraden Schichten (101) zu verbinden;
   mehrere gerade Schichten (102), worin jede der mehreren geraden Schichten (102) mit einem zweiten Schlitz (105) ausgebildet ist und nicht an eine andere der mehreren geraden Schichten (102) angrenzt;
   einen zweiten Durchgang, der in dem zweiten Schlitz (105) ausgebildet ist; und
   mehrere zweite Verbindungsabschnitte (104), die den mehreren geraden Schichten (102) entsprechen, die in dem zweiten Schlitz (105) ausgebildet sind und ausgestaltet sind, derart dass sie den zweiten Durchgang (V2) und die mehreren geraden Schichten (102) verbinden;
   worin eine der mehreren ungeraden Schichten (101) an eine der mehreren geraden Schichten (102) angrenzt, um eine gestaffelte Schichtstruktur auszubilden.

2. Kondensatoreinheit nach Anspruch 1, **dadurch gekennzeichnet, dass** die mehreren ungeraden Schichten (101), der erste Schlitz (105), die mehreren geraden Schichten (102) und der zweite Schlitz (105) mit einer rechteckigen Topologie ausgebildet sind.

3. Kondensatoreinheit nach Anspruch 1, **dadurch gekennzeichnet, dass** eine erste Anzahl der mehreren ungeraden Schichten (101) und eine zweite Anzahl der mehreren geraden Schichten (102) ganze Zahlen größer 1 sind.

4. Kondensatoreinheit nach Anspruch 1, **dadurch gekennzeichnet, dass** mehrere Kondensatoreinheiten derart angeordnet sind, dass sie die Kondensatoranordnung einer m*n-Matrix ausbilden, worin m und n ganze Zahlen größer Null sind.

5. Kondensatoreinheit nach Anspruch 1, **dadurch gekennzeichnet, dass** die Kondensatoranordnung (50) umfasst:

   eine erste Kondensatoreinheit (501);
   eine zweite Kondensatoreinheit (502), die mit der ersten Kondensatoreinheit (501) gekoppelt und ihr benachbart ist;
   eine dritte Kondensatoreinheit (503), die mit der ersten Kondensatoreinheit (501) gekoppelt und ihr benachbart ist; und
   eine vierte Kondensatoreinheit (504), die mit der zweiten Kondensatoreinheit (502) und der dritten Kondensatoreinheit (503) gekoppelt und an diese angrenzt, und nicht an die erste Kondensatoreinheit (501) angrenzt;
   worin horizontale Kanten der ersten Kondensatoreinheit entlang einer ersten Richtung (X) an horizontalen Kanten der zweiten Kondensatoreinheit (502) ausgerichtet sind, und vertikale Kanten der ersten Kondensatoreinheit (501) entlang einer zweiten Richtung (Y) an vertikalen Kanten der dritten Kondensatoreinheit (503) ausgerichtet sind;
   worin sich Projektionen der ersten, zweiten, dritten und vierten Kondensatoreinheit (501, 502, 503, 504) auf eine Ebene, die durch die erste und zweite Richtung (X, Y) ausgebildet wird, nicht überlappen.

6. Kondensatoreinheit nach Anspruch 1, **dadurch gekennzeichnet, dass** die Kondensatoranordnung (60) umfasst:

   eine erste Kondensatoreinheit (601);
   eine zweite Kondensatoreinheit (602), die mit der ersten Kondensatoreinheit (601) gekoppelt und ihr benachbart ist;
   eine dritte Kondensatoreinheit (603), die mit der ersten Kondensatoreinheit (601) gekoppelt und ihr benachbart ist; und
   eine vierte Kondensatoreinheit (604), die mit der zweiten und der dritten Kondensatoreinheit (602, 603) gekoppelt ist und an diese angrenzt, aber nicht an die erste Kondensatoreinheit (601) angrenzt;

worin zwei horizontale Kanten der ersten Kondensatoreinheit (601) entlang einer ersten Richtung (X) an zwei horizontalen Kanten der zweiten Kondensatoreinheit (602), einer horizontalen Kante der dritten Kondensatoreinheit (603) und einer horizontalen Kante der vierten Kondensatoreinheit (604) ausgerichtet sind;
worin zwei vertikale Kanten der ersten Kondensatoreinheit (601) entlang einer zweiten Richtung (Y) nicht mit einer vertikalen Kante der dritten und vierten Kondensatoreinheit (603, 604) ausgerichtet sind;
worin sich Projektionen der ersten, zweiten, dritten und vierten Kondensatoreinheit (601, 602, 603, 604) auf eine Ebene, die durch die erste und zweite Richtung (X, Y) gebildet wird, nicht überlappen.

7. Kondensatoreinheit nach Anspruch 1, **dadurch gekennzeichnet, dass** die Kondensatoranordnung (70) umfasst:

eine erste Kondensatoreinheit (701);
eine zweite Kondensatoreinheit (702), die mit der ersten Kondensatoreinheit (701) gekoppelt und benachbart ist;
eine dritte Kondensatoreinheit (703); und
eine vierte Kondensatoreinheit (704), die mit der dritten Kondensatoreinheit (703) gekoppelt und ihr benachbart ist;
worin zwei horizontale Kanten der ersten Kondensatoreinheit (701) entlang einer ersten Richtung (X) mit zwei horizontalen Kanten der zweiten Kondensatoreinheit (702) ausgerichtet sind, und zwei vertikale Kanten der ersten Kondensatoreinheit (701) entlang einer zweiten Richtung (Y) mit zwei vertikalen Kanten der dritten Kondensatoreinheit (703) ausgerichtet sind;
worin eine Projektion der ersten Kondensatoreinheit (701) auf eine Ebene, die durch die erste und zweite Richtung (X, Y) ausgebildet wird, mit einer Projektion der dritten Kondensatoreinheit (703) überlappt, und die Projektion der ersten Kondensatoreinheit (701) nicht mit Projektionen der zweiten und vierten Kondensatoreinheit (702, 704) auf die Ebene überlappen.

8. Kondensatoreinheit nach Anspruch 1, **dadurch gekennzeichnet, dass** die Kondensatoranordnung (80) umfasst:

eine erste Kondensatoreinheit (801);
eine zweite Kondensatoreinheit (802), die mit der ersten Kondensatoreinheit (801) gekoppelt ist und an diese angrenzt;
eine dritte Kondensatoreinheit (803); und
eine vierte Kondensatoreinheit (804), die mit der dritten Kondensatoreinheit (803) gekoppelt und ihr benachbart ist;
worin zwei horizontale Kanten der ersten Kondensatoreinheit (801) entlang einer ersten Richtung (X) mit zwei horizontalen Kanten der zweiten Kondensatoreinheit (802) ausgerichtet sind;
worin zwei vertikale Kanten der ersten Kondensatoreinheit (801) entlang einer zweiten Richtung (Y) nicht an einer vertikalen Kante der dritten Kondensatoreinheit (803) ausgerichtet sind;
worin eine Projektion der ersten Kondensatoreinheiten (801) auf eine Ebene, die durch die erste und zweite Richtung (X, Y) gebildet wird, mit einer Projektion der dritten Kondensatoreinheit (803) überlappt, und die Projektion der ersten Kondensatoreinheit (801) nicht mit Projektionen der zweiten und vierten Kondensatoreinheiten (802, 804) auf die Ebene überlappen.

9. Kondensatoreinheit nach Anspruch 1, **dadurch gekennzeichnet, dass** die mehreren ungeraden Schichten (101) mit einer Stromquelle und einem Funkfrequenzsignal verbunden sind und die mehreren geraden Schichten (102) mit einer Masse verbunden sind.

**Revendications**

1. Unité de condensateur (10) avec une structure à couches échelonnées, pour un réseau de condensateurs comprenant une pluralité d'unités de condensateurs dans laquelle une et une autre de la pluralité d'unités de condensateurs sont connectées sans soudure côte à côte, **caractérisée en ce qu'**elle comprend:

une pluralité de couches impaires (101), dans laquelle chacune de la pluralité de couches impaires (101) est formée avec une première fente (105), et non adjacente à une autre de la pluralité de couches impaires (101);
une première via (V1) formée dans la première fente (105);
une pluralité de premières parties de connexion (103) correspondant à la pluralité de couches impaires (101), formées dans la première fente (105), et configurées pour connecter le premier via (V1) et la pluralité de couches impaires (101);
une pluralité de couches paires (102), dans laquelle chacune de la pluralité de couches paires (102) est formée avec une deuxième fente (105), et non adjacente à une autre de la pluralité de couches paires (102);
un deuxième passage formé dans la deuxième fente (105); et
une pluralité de deuxièmes parties de connexion (104) correspondant à la pluralité de couches paires (102), formées dans la deuxième fente (105), et configurées pour connecter le deuxième via (V2) et la pluralité de couches paires (102);

dans lequel une de la pluralité de couches impaires (101) est adjacente à une de la pluralité de couches paires (102) pour former une structure à couches échelonnées.

2. Unité de condensateur de la revendication 1, **caractérisée en ce que** la pluralité de couches impaires (101), la première fente (105), la pluralité de couches paires (102), la deuxième fente (105) sont formées avec une topologie rectangulaire.

3. Unité de condensateur de la revendication 1, **caractérisée en ce qu'**un premier nombre de la pluralité de couches impaires (101) et un deuxième nombre de la pluralité de couches paires (102) sont des entiers supérieurs à 1.

4. Unité de condensateur de la revendication 1, **caractérisée en ce qu'**une pluralité d'unités de condensateur est disposée pour former le réseau de condensateur d'une matrice m*n, dans laquelle m et n sont des entiers supérieurs à zéro.

5. Unité de condensateur de la revendication 1, **caractérisée en ce que** le réseau de condensateurs (50) comprend:

une première unité de condensateur (501);
une deuxième unité de condensateur (502) couplée et adjacente à la première unité de condensateur (501);
une troisième unité de condensateur (503) couplée et adjacente à la première unité de condensateur (501); et
une quatrième unité de condensateur (504) couplée et adjacente à la deuxième unité de condensateur (502) et à la troisième unité de condensateur (503), et non adjacente à la première unité de condensateur (501);
dans lequel les bords horizontaux de la première unité de condensateur le long d'une première direction (X) sont alignés avec les bords horizontaux de la deuxième unité de condensateur (502), et les bords verticaux de la première unité de condensateur (501) le long d'une deuxième direction (Y) sont alignés avec les bords verticaux de la troisième unité de condensateur (503);
dans lequel les projections des première, deuxième, troisième et quatrième unités de condensateur (501, 502, 503, 504) sur un plan formé par les première et deuxième directions (X, Y) ne se chevauchent pas.

6. Unité de condensateur de la revendication 1, **carac-**

**térisée en ce que** le réseau de condensateurs (60) comprend:

une première unité de condensateur (601);
une deuxième unité de condensateur (602) couplée et adjacente à la première unité de condensateur (601);
une troisième unité de condensateur (603) couplée et adjacente à la première unité de condensateur (601); et
une quatrième unité de condensateur (604) couplée et adjacente aux deuxième et troisième unités de condensateur (602, 603), et non adjacente à la première unité de condensateur (601);
dans lequel deux bords horizontaux de la première unité de condensateur (601) le long d'une première direction (X) sont alignés avec deux bords horizontaux de la deuxième unité de condensateur (602), un bord horizontal de la troisième unité de condensateur (603), et un bord horizontal de la quatrième unité de condensateur (604);
dans lequel deux bords verticaux de la première unité de condensateur (601) le long d'une deuxième direction (Y) ne sont alignés avec aucun bord vertical des troisième et quatrième unités de condensateur (603, 604);
dans lequel les projections des première, deuxième, troisième et quatrième unités de condensateur (601, 602, 603, 604) sur un plan formé par les première et deuxième directions (X, Y) ne se chevauchent pas.

7. Unité de condensateur de la revendication 1, **caractérisée en ce que** le réseau de condensateurs (70) comprend:

une première unité de condensateur (701);
une deuxième unité de condensateur (702) couplée et adjacente à la première unité de condensateur (701);
une troisième unité de condensateur (703); et
une quatrième unité de condensateur (704) couplée et adjacente à la troisième unité de condensateur (703);
dans lequel deux bords horizontaux de la première unité de condensateur (701) le long d'une première direction (X) sont alignés avec deux bords horizontaux de la deuxième unité de condensateur (702), et deux bords verticaux de la première unité de condensateur (701) le long d'une deuxième direction (Y) sont alignés avec deux bords verticaux de la troisième unité de condensateur (703);
dans lequel une projection de la première unité de condensateur (701) sur un plan formé par les première et deuxième directions (X, Y) est chevauchée par une projection de la troisième unité de condensateur (703), et la projection de la première unité de condensateur (701) n'est pas chevauchée par des projections des deuxième et quatrième unités de condensateur (702, 704) sur le plan.

8. Unité de condensateur de la revendication 1, **caractérisée en ce que** le réseau de condensateurs (80) comprend:

une première unité de condensateur (801);
une deuxième unité de condensateur (802) couplée et adjacente à la première unité de condensateur (801);
une troisième unité de condensateur (803); et
une quatrième unité de condensateur (804) couplée et adjacente à la troisième unité de condensateur (803);
dans lequel deux bords horizontaux de la première unité de condensateur (801) le long d'une première direction (X) sont alignés avec deux bords horizontaux de la deuxième unité de condensateur (802);
dans lequel deux bords verticaux de la première unité de condensateur (801) le long d'une deuxième direction (Y) ne sont pas alignés avec un bord vertical quelconque de la troisième unité de condensateur (803);
dans lequel une projection des premières unités de condensateur (801) sur un plan formé par les première et deuxième directions (X, Y) est chevauchée par une projection de la troisième unité de condensateur (803), et la projection de la première unité de condensateur (801) n'est pas chevauchée par des projections des deuxième et quatrième unités de condensateur (802, 804) sur le plan.

9. Unité de condensateur de la revendication 1, **caractérisée en ce que** la pluralité de couches impaires (101) sont connectées à une source d'alimentation et à un signal radiofréquence, et la pluralité de couches paires (102) sont connectées à une masse.

FIG. 1

FIG. 2

FIG. 3

EP 3 683 812 B1

FIG. 4

FIG. 5

101

V1

Z

Y X

FIG. 6

V2

102

Z

Y X

FIG. 7

FIG. 8

FIG. 9

FIG. 10

FIG. 11

EP 3 683 812 B1

FIG. 12

FIG. 13

FIG. 14

FIG. 15

100

$V_{bias}$

Circuits

Circuits

FIG. 16

EP 3 683 812 B1

FIG. 17

FIG. 18

FIG. 19

FIG. 20

Conduction loss

$R_{feed-in}$

$R_{feed-out}$

Circuits

FIG. 21

FIG. 22

FIG. 23

**REFERENCES CITED IN THE DESCRIPTION**

**Patent documents cited in the description**

- US 2010084738 A1
- US 2010134213 A1
- US 6434730 B1
- US 2005017320 A1